# FASCICULE DE BREVET EUROPEEN

(11) **EP 2 189 051 B1**
(45) Date de publication et mention de la délivrance du brevet: **09.03.2011**
(21) Numéro de dépôt: 08787544.9
(22) Date de dépôt: 28.08.2008
(51) Int. Cl.: H05K 13/04, H05K 7/20, H01L 23/40

(54) **DISPOSITIF DE DEMONTAGE DE COMPOSANTS ELECTRONIQUES DE PUISSANCE ET PROCEDE POUR LA MISE EN OEUVRE DU DISPOSITIF**
EINRICHTUNG ZUM AUSEINANDERBAUEN VON ELEKTRONISCHEN LEISTUNGSKOMPONENTEN UND VERFAHREN ZUR IMPLEMENTIERUNG DER EINRICHTUNG
DEVICE FOR DISASSEMBLING ELECTRONIC POWER COMPONENTS AND METHOD FOR IMPLEMENTING SAID DEVICE

(30) Priorité: 14.09.2007 FR 0706461
(43) Date de publication de la demande: 26.05.2010
(73) Titulaire: THALES, 92200 Neuilly-sur-Seine (FR)
(72) Inventeur: DARGES, Bernard, F-95320 Saint Leu La Foret (FR)
(74) Mandataire: Dudouit, Isabelle
(86) Numéro de dépôt international: PCT/EP2008/061305
(87) Numéro de publication internationale: WO 2009/033959

(56) Documents cités:
- US-A- 3 874 443
- US-A- 4 648 008
- US-B1- 6 674 164
- US-B2- 6 418 024

## Description

L'invention concerne un dispositif pour le démontage de composants électroniques de puissance refroidis par radiateur.

De nombreux circuits électroniques comportent des composants de puissance qu'il faut refroidir pour limiter leur température et ainsi conserver une bonne fiabilité de fonctionnement.
Les calories dégagées par ces composants électroniques de puissance sont, en général, transmisses par contact thermique vers un radiateur métallique rayonnant les calories dans le milieu environnant. Dans le cas de fortes dissipations thermiques dans un faible volume, l'évacuation des calories transmises au radiateur est effectuée par un liquide de refroidissement.

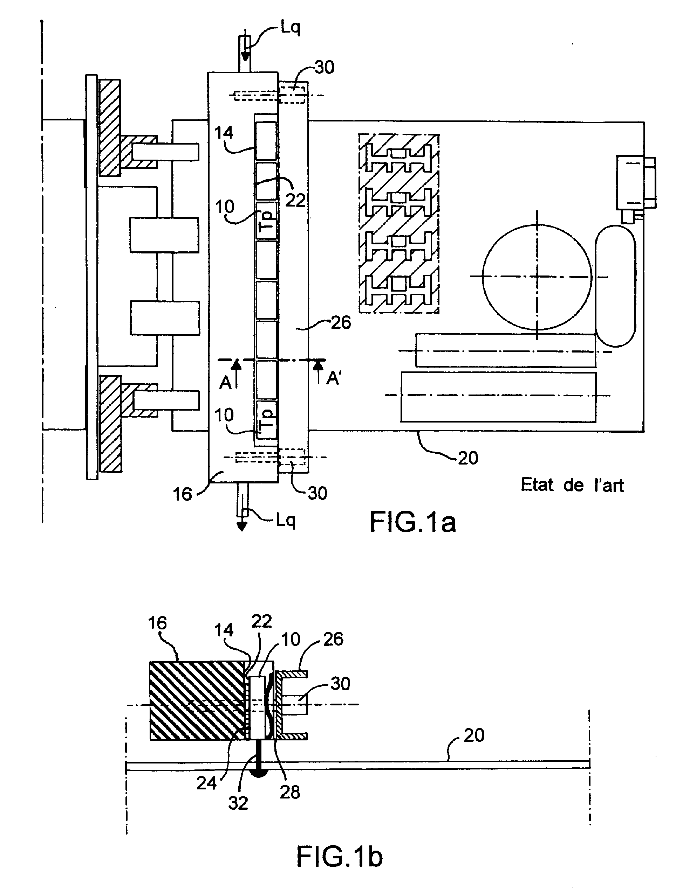

La figure 1a montre un exemple de réalisation d'une carte électronique de l'état de l'art pour générateur de chauffage haute fréquence, d'acronyme HFI, utilisé notamment dans le chauffage par induction électromagnétique, par pertes diélectriques ou par plasma.
Ce type de générateur de chauffage comporte une pluralité de cartes basique (ou modules état solide) comportant chacune plusieurs transistors de puissance Tp 10 dont les boîtiers métalliques sont en contact thermique avec une face de refroidissement 14 d'un radiateur 16. Les puissances dissipées étant importantes dans un volume restreint, le radiateur 16 est refroidi par un liquide Lq circulant dans la masse du radiateur.
Le radiateur 16 en forme de barre de section rectangulaire est solidaire, par la face de refroidissement 14, des transistors de puissance Tp 10. Dans cet exemple de réalisation, les boîtiers des transistors sont de type TO247 de forme parallélépipédique comportant chacun une face de refroidissement du boîtier 22 appliquée contre la face de refroidissement 14 du radiateur 16 par l'intermédiaire d'un film 24 ou d'une pâte conductrice thermique.

La figure 1b montre une vue en coupe partielle selon les axes AA' de la carte de la figure 1 a montrant un transistor Tp 10 monté sur le radiateur 16.
Chaque transistor de puissance est plaqué sur la face de refroidissement 14 du radiateur 16 par une barre métallique 26 en forme de U et une lame de ressort 28. Des vis de serrage 30 de la barre métallique 26 se vissant sur le radiateur 16 assurent un contact permanent avec une certaine pression des transistors Tp 10 sur le radiateur 16.
L'interface entre le radiateur 16 et le transistor Tp est habituellement une pâte ou un film bon conducteur de la chaleur offrant la plus faible résistance thermique pour évacuer les calories dégagées par le transistor vers le radiateur.

Dans ce tipe de générateur de chauffage industriel, le démontage des modules et le remplacement d'un transistor défectueux doit se faire dans un temps très court pour des aspects coût. Par exemple, chaque générateur de chauffage peut comporter de 12 à 50 modules. Dans une application radio, le nombre de modules peut atteindre 400. Dans un émetteur radio, le temps de changement d'un module ne doit pas excéder 1 mn.

Une carte électronique de l'état de l'art, telle que représentée aux figures 1 a et 1 b, présente des inconvénients lors d'une opération de maintenance. En effet, le démontage d'un ou plusieurs transistors, après desserrage de la barre métallique 26 pour les libérer, demande un effort important pour séparer le transistor à remplacer du radiateur qui se trouve «collé » par effet ventouse par le film 24 ou la pâte conductrice entre les faces de refroidissement du transistor et du radiateur.
Le dépanneur doit, pour exercer un effort suffisant et séparer le transistor du radiateur, utiliser un tournevis ou des outils équivalents. Une telle action pour démonter un transistor Tp peut abîmer le radiateur qui ne présentera plus un état de surface satisfaisant pour l'application d'un autre transistor de remplacement. En outre le temps nécessaire au démontage conduit à un coût de maintenance important compte tenu du nombre important de transistors utilisés dans un générateur.

Dans certaines cartes, pour diminuer l'effort de traction nécessaire au décollage du transistor de la surface du radiateur, un film conducteur thermique entre le radiateur et le transistor de résistance thermique médiocre est utilisé, ce qui nécessite un refroidissement du radiateur plus efficace et donc un coût du dispositif de refroidissement du générateur plus élevé.
Une autre solution pour démonter les transistors des radiateurs lorsqu'ils sont desserrés consiste à les faire glisser sur la face de refroidissement du radiateur jusqu'à leur sortie par un des bords du radiateur mais lorsque le radiateur comporte d'autres composants montés à proximité (montage de la figure 1 a) cette opération devient impossible. Dans ce cas, chaque composant doit être rendu indépendant en coupant leurs pattes de connexion électrique 32 ou, en dessoudant tous les transistors de la carte 20.
Ces différentes opérations de démontage aboutissent à un coût de maintenance élevée du aux temps de démontage et de montage importants des transistors, mais aussi à une éventuelle remise en état du radiateur qui pourrait être abîmé lors de l'opération de démontage du transistor.

Un dispositif de démontage de composants électroniques est connu du document US-B2-6 418 024.

Pour pallier les inconvénients de la maintenance des cartes électroniques de l'état de l'art comportant des composants de puissance, l'invention propose un dispositif de démontage d'au moins un composant électronique de puissance d'un radiateur de refroidissement du composant, le composant et le radiateur comportant chacun une respective face de refroidissement en contact thermique,
caractérisé en ce qu'une partie de la face de refroidissement du composant monté sur le radiateur est libre et accessible à un corps mobile par rapport au radiateur, le radiateur comportant un élément mobile solidaire du radiateur destiné à pousser le corps mobile contre la partie libre de la face de refroidissement du composant pour séparer le composant du radiateur.

Dans une réalisation, le corps mobile est une barre de section rectangulaire et l'élément mobile solidaire du radiateur est une vis dans un trou fileté du radiateur.

L'invention concerne aussi un procédé de démontage d'au moins un composant électronique de puissance d'un radiateur de refroidissement du composant, par la mise en ouvre du dispositif selon l'invention, le composant et le radiateur comportant chacun une respective face de refroidissement en contact thermique,
caractérisé en ce que, une partie de la face de refroidissement du composant monté sur le radiateur étant libre et accessible à un corps mobile par rapport au radiateur, le radiateur comportant un élément mobile solidaire du radiateur destiné à pousser le corps mobile contre la partie libre de la face de refroidissement du composant, le procédé consiste au moins à insérer le corps mobile entre l'élément mobile solidaire du radiateur et la partie libre de la face de refroidissement du composant et à pousser le corps mobile par l'élément mobile solidaire du radiateur pour séparer le composant du radiateur.

Un principal but du dispositif de démontage selon l'invention est de réduire notablement le temps de démontage des composants électroniques de puissance de leurs radiateurs et donc le coût de maintenance des cartes électroniques comportant des nombreux composants de puissance montés sur radiateur.
Un autre but est de faciliter l'opération de remplacement de composants de puissance.

L'invention sera mieux comprise à l'aide d'un exemple de réalisation d'un dispositif pour la mise en oeuvre du procédé de démontage selon l'invention en référence aux figures ci-annexées dans lesquelles :
- la figure 1a, déjà décrite, montre un exemple de réalisation d'une carte électronique de l'état de l'art ;
- la figure 1b, déjà décrite, montre une vue en coupe partielle de la carte de la figure 1a.
- la figure 2a montre la carte électronique de la figure 1 a comportant un radiateur du dispositif de démontage des composants selon l'invention ;
- la figure 2b montre un outil pour assurer la mise en ouvre du procédé, selon l'invention ;
- la figure 2c montre une vue en perspective du radiateur de la carte de la figure 2a ;
- la figure 2d montre une vue en coupe du radiateur de la figure 2b du côté de ses extrémités ;
- la figure 2e montre une vue en coupe dudit radiateur de la figure 2b du coté d'une zone centrale de sa longueur ;
- la figure 2f montre une coupe partielle de la carte électronique comportant le radiateur de la figure 2b ; et
- les figures 3a, 3b et 3c montrent différentes étapes du procédé de démontage des transistors selon l'invention.

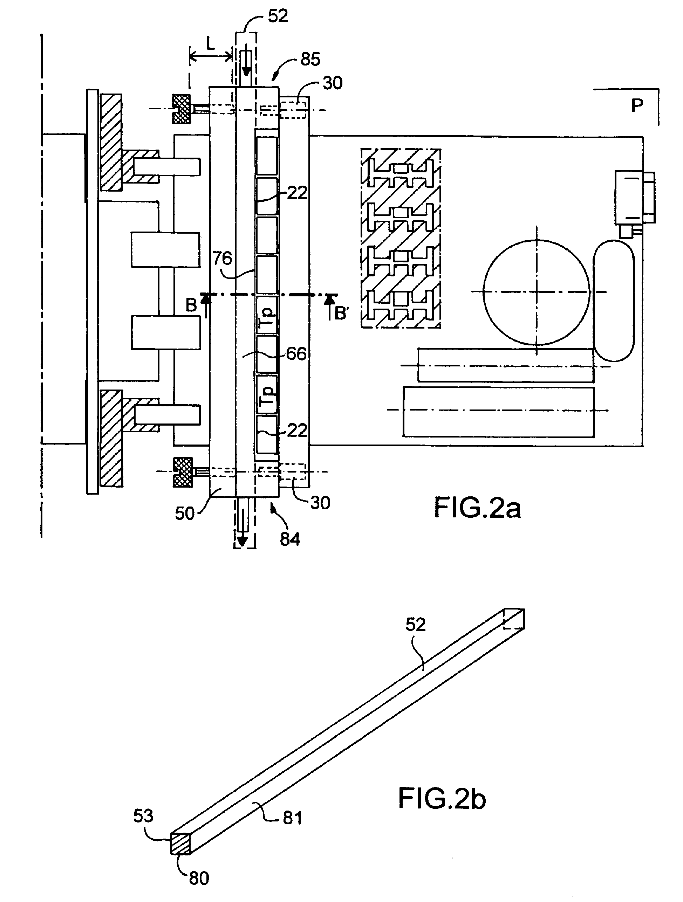

La figure 2a montre la carte électronique de la figure 1 a comportant un radiateur 50 du dispositif de démontage des composants selon l'invention. La figure 2b montre un outil 52 pour assurer la mise en ouvre du procédé, selon l'invention, de démontage des transistors de puissance Tp 10 du radiateur 50.
Dans cet exemple de réalisation de la figure 2a les transistors (ou composants) Tp sont des boîtiers de type TO247 de forme parallélépipédique comportant un bord supérieur 78, un bord inférieur du côté des pattes de connexion électrique avec la carte, une face de refroidissement 22 entre ces deux bords destinée à être appliquée contre une face de refroidissement 76 du radiateur 50.

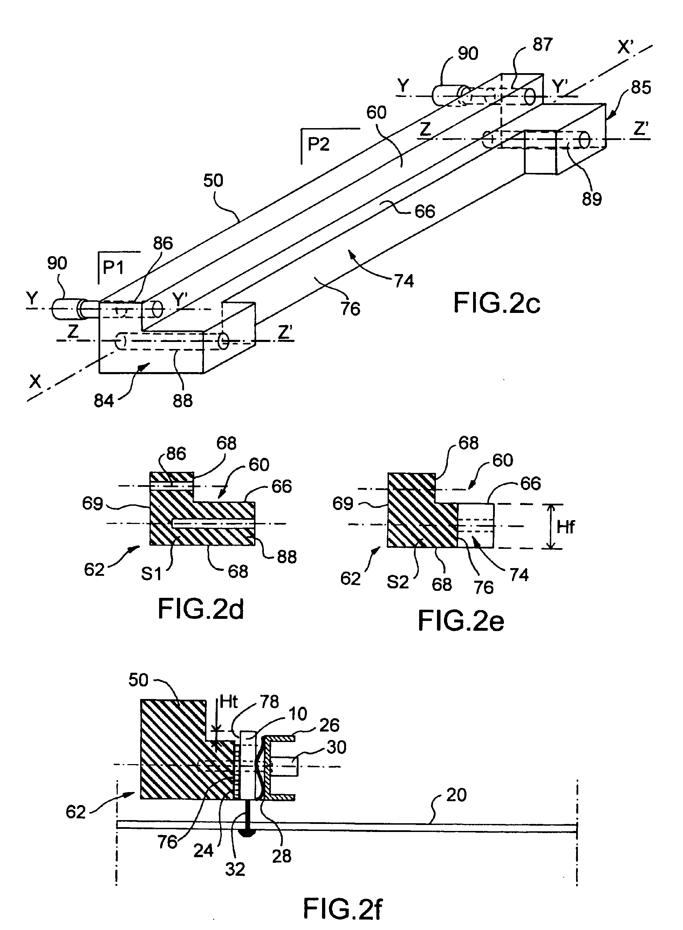

La figure 2c montre une vue en perspective du radiateur 50 de la carte de la figure 2a.
Le dispositif de démontage des transistors de puissance comporte le radiateur 50 de forme allongée, selon un axe XX' et de section en forme d'équerre.
La figure 2d montre une vue en coupe du radiateur de la figure 2b du côté de ses extrémités selon un plan P1 perpendiculaire à l'axe XX' et la figure 2e une vue en coupe dudit radiateur 50 de la figure 2b selon un plan P2 perpendiculaire à l'axe XX' du coté d'une zone centrale de sa longueur.
Le radiateur comporte un corps présentant une première section S1 en forme d'équerre du côté de ses extrémités et sur sa longueur une surface intérieure 60 et une surface extérieure 62 parallèles, chacune en forme de L.

La surface intérieure 60 comporte deux faces perpendiculaires formant un premier L, une première face 66 et une deuxième face 67 perpendiculaire à la première.
La surface extérieure 62 comporte deux autres faces perpendiculaires formant un second L, une première autre face 68 et une deuxième autre face 69 perpendiculaire à la première.
La figure 2f montre une coupe partielle selon BB' de la carte électronique de la figure 2a comportant le radiateur 50, au niveau de la zone centrale du radiateur perpendiculaire au plan P de la carte électronique 20.

Le corps du radiateur présente, en outre, dans la partie centrale de sa longueur, une deuxième section S2 aussi en forme d'équerre mais ayant un côté de l'équerre de plus faible largeur que le même côté de l'équerre de section S1 au niveau des extrémités du radiateur et formant ainsi un logement 74 pour le positionnement des boîtiers des transistors Tp.
Le logement 74 comporte une face de refroidissement 76 du radiateur de hauteur Hf reliant la surface intérieure 60 et la surface extérieure 62 en formes de L du corps du radiateur 50.

Comme dans la carte de la figure 1a, chaque transistor de puissance Tp 10 est plaqué sur la face de refroidissement 76 du radiateur 50 par la barre métallique 26 et la lame de ressort 28 à l'aide des vis de serrage 30 vissées sur le radiateur 50 assurant un contact permanent avec une certaine pression du transistor Tp sur le radiateur et, selon une principale caractéristique de l'invention, le bord supérieur 78 du boiter du transistor 10 dépasse de la face de refroidissement 76 du radiateur 50 d'une hauteur Ht pour assurer la mise en ouvre du procédé de démontage des transistors Tp.
Dans cet exemple de réalisation, la hauteur de dépassement Ht est de 1 mm.
Le dispositif de démontage comporte le corps mobile 52 sous la forme d'une barre de section S3 rectangulaire (voir figure 2b) qui est destinée à glisser par une première face 80 de ses quatre faces sur la première face 66 de la surface intérieure 60 en forme de L du radiateur 50 et à s'appliquer, par une deuxième face 81 perpendiculaire à la première 80, sur les bords supérieurs 78 des boîtiers des transistors de puissance 10 dépassant de la surface de refroidissement 76 du radiateur 50.

Le radiateur 50 comporte en outre :
- au niveau de chacune des ses deux extrémités 84, 85, des premiers trous filetés 86, 87 selon des axes YY' perpendiculaires à l'axe XX' débouchant par la deuxième face 68 de la surface intérieure 60 en forme de L,
- des vis de poussée 90 destinées à être vissée dans chacun des premiers trous filetés 86, 87 du radiateur 50 et débouchant du côté de la deuxième face 68 de la première surface en L,
- au niveau de chacune des ses deux extrémités 84, 85, dans la partie du corps du radiateur de section S1, des deuxièmes trous filetés 88, 89 selon des axes ZZ" perpendiculaires à l'axe XX' débouchant de part et d'autre du logement 74 pour les vis de serrage 30.

Les vis de poussée 90 seront de longueur L suffisante pour déboucher du côté de la deuxième face 68 de la première surface 60 en L du radiateur et pousser la barre de poussée 52 au-delà du contact de ladite barre de poussée avec la partie supérieure 78 des transistors afin de pouvoir les décoller du radiateur.

Nous allons par la suite expliquer le procédé de démontage, selon l'invention, des transistors Tp plaqués contre le radiateur 50.

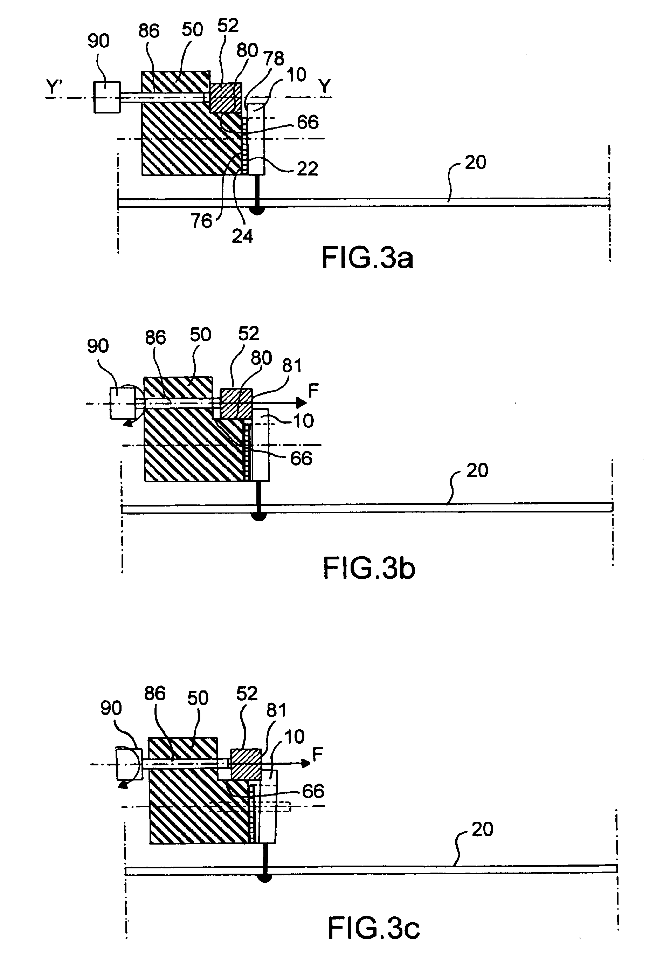

Les figures 3a, 3b, 3c montrent différentes étapes du procédé de démontage des transistors selon l'invention.
En cas de panne d'un ou plusieurs transistors Tp la mise en ouvre du procédé de démontage des transistors de puissance, selon l'invention, comporte les étapes suivantes :
Première étape : dévissage des vis de serrage 30 pour desserrer les transistors Tp plaqués contre le radiateur 50 par la barre métallique 26 et la lame de ressort 28 (voir figure 2f). Les transistors restent néanmoins collés sur le radiateur 50 par le film ou la pâte thermique 24 insérée entre la face de refroidissement 76 du radiateur et les faces de refroidissement 22 des transistors ;
Deuxième étape : mise en place de la barre de poussée 52 par sa première face 80 sur la première face 66 de la première surface 60 en L du radiateur 50 (voir figure 3a) et vissage des vis de poussée 90 dans les premiers trous filetés 86, 87.
La barre de poussée 52 est représentée (en pointillé) en position sur le radiateur 50 sur la figure 2a.

Troisième étape : poursuite du vissage des vis de poussée 90 dans les premiers trous filetés 86, 87 du radiateur 50 pour déplacer la barre de poussée vers les transistors et l'amener en contact par sa deuxième face 81 avec la partie supérieure 78 des boîtiers des transistors de puissance Tp dépassant de la face de refroidissement 76 du radiateur.

Quatrième étape : poursuite du vissage des vis de poussée 90 dans les premiers trous filetés 86, 87 produisant un effort de poussée F sur la partie supérieure 78 des boîtiers des transistors Tp jusqu'à leur décollage du radiateur (voir figure 3c), puis retrait de la barre de poussée 52 et dévissage des vis de poussée 90 du radiateur 50.

Les transistors Tp étant décollés du radiateur 50, le ou les transistors défectueux pourront être dessoudés de la carte 20 sans difficulté et remplacés par d'autres transistors
Après remplacement des transistors, remise en place de la barre métallique 26 et le ressort 28 sur le radiateur 50 pour plaquer à nouveau les transistors Tp sur la face de refroidissement 76 du radiateur 50 à l'aide des vis de serrage 30.
Avant cette dernière étape le film ou la pâte thermique peut être changée pour améliorer l'évacuation des calories des transistors vers le radiateur.

Dans le cas de la carte électronique pour émetteur HFI le radiateur 50 du dispositif selon l'invention peut être simplement obtenu en usinant le radiateur 16 d'origine. L'usinage consiste principalement dans le rabotage de la partie supérieure du radiateur d'origine pour obtenir la surface intérieure 60 en forme de L du radiateur du dispositif et ainsi pouvoir placer la barre de poussée au contact avec l'ensemble des transistors sur une hauteur d'environ 1 mm.

Le dispositif et le procédé selon l'invention comportent les avantages suivants :
- conservation des transistors non défectueux, les pattes des transistors ne devant plus être coupées,
- le radiateur n'est plus endommagé par des outils inadaptés lors d'une opération de remplacement des transistors,
- l'accessibilité par les cotés en est facilitée,
- un gain de temps de maintenance très significatif,
- un seul outil (barre de poussée 52 et deux vis de serrage 90) pour le démontage des transistors des multiples cartes d'un générateur de chauffage.

## Revendications

1. Dispositif de démontage d'au moins un composant électronique de puissance (10) d'un radiateur (16, 50) de refroidissement du composant, le composant et le radiateur comportant chacun une respective face de refroidissement (14, 22, 76) en contact thermique,
**caractérisé en ce qu'**une partie (78) de la face de refroidissement du composant monté sur le radiateur est libre et accessible à un corps mobile (52) par rapport au radiateur, le radiateur comportant un élément mobile (90) solidaire du radiateur destiné à pousser le corps mobile (52) contre la partie (78) libre de la face de refroidissement (22) du composant pour séparer le composant du radiateur.

2. Dispositif de démontage selon la revendication 1, **caractérisé en ce que** le corps mobile (52) est une barre de section rectangulaire S3 et l'élément mobile solidaire du radiateur est une vis (90) dans un trou fileté (86, 87) du radiateur (50).

3. Dispositif de démontage selon l'une des revendications 1 ou 2, **caractérisé en ce que** le radiateur (50), de forme allongée selon un axe XX' comporte un corps présentant une première section S1 en forme d'équerre du côté de ses extrémités (84, 85) et, sur sa longueur, une surface intérieure (60) et une surface extérieure (62) parallèles, chacune en forme de L, la surface intérieure (60) comportant deux faces perpendiculaires formant un premier L, une première face (66) et une deuxième face (67) perpendiculaire à la première.

4. Dispositif de démontage selon l'une des revendications 1 à 3, **caractérisé en ce que** les transistors Tp des boîtiers de forme parallélépipédique comportant un bord supérieur (78), un bord inférieur du côté des pattes de connexion électrique (32) avec la carte, une face de refroidissement (22) entre ces deux bords destinée à être appliquée contre la face de refroidissement (76) du radiateur (50).

5. Dispositif de démontage selon la revendication 4, **caractérisé en ce que** le corps du radiateur présente, dans la partie centrale de sa longueur, une deuxième section S2 aussi en forme d'équerre mais ayant un côté de l'équerre de plus faible largeur que le même côté de l'équerre de section S1 au niveau des extrémités du radiateur et formant ainsi un logement (74) pour le positionnement des boîtiers des transistors Tp, le logement (74) comportant une face de refroidissement (76) du radiateur de hauteur Hf reliant la surface intérieure (60) et la surface extérieure (62) en formes de L du corps du radiateur (50).

6. Dispositif de démontage selon la revendication 5, **caractérisé en ce que** le bord supérieur (78) du boiter du transistor Tp (10) dépasse de la face de refroidissement (76) du radiateur (50) d'une hauteur Ht pour assurer la mise en ouvre d'un procédé de démontage des transistors Tp.

7. Dispositif de démontage selon la revendication 6, **caractérisé en ce que** la hauteur de dépassement Ht est de 1 mm.

8. Dispositif de démontage selon l'une des revendications 3 à 7, **caractérisé en ce que** la barre (52) de section S3 rectangulaire est destinée à glisser par une première face (80) de ses quatre faces sur la première face (66) de la surface intérieure (60) en forme de L du radiateur (50) et à s'appliquer, par une deuxième face (81) perpendiculaire à la première (80), sur les bords supérieurs (78) des boîtiers des transistors (10) dépassant de la surface de refroidissement (76) du radiateur (50).

9. Dispositif de démontage selon la revendication 3 à 8, **caractérisé en ce que** le radiateur (50) comporte :
- au niveau de chacune des ses deux extrémités (84, 85), des premiers trous filetés (86, 87) selon des axes YY' perpendiculaires à l'axe XX' débouchant par la deuxième face (68) de la surface intérieure (60) en forme de L,
- des vis de poussée (90) destinées à être vissées dans chacun des premiers trous filetés (86, 87) du radiateur et débouchant du côté de la deuxième face (68) de la première surface en L,
- au niveau de chacune des ses deux extrémités (84, 85), dans la parie du corps du radiateur de section S1, des deuxièmes trous filetés (88, 89) selon des axes ZZ" perpendiculaires à l'axe XX' débouchant de part et d'autre du logement (74) pour les vis de serrage (30).

10. Procédé de démontage d'au moins un composant électronique de puissance (10) d'un radiateur (16, 50) de refroidissement du composant, par la mise en ouvre du dispositif selon l'une des revendications 1 à 9, le composant et le radiateur comportant chacun une respective face de refroidissement (14, 22, 76) en contact thermique,
**caractérisé en ce qu'**une partie (78) de la face de refroidissement du composant (10) monté sur le radiateur étant libre et accessible à un corps mobile (52) par rapport au radiateur (50), le radiateur comportant un élément mobile (90) solidaire du radiateur destiné à pousser le corps mobile (52) contre la partie (78) libre de la face de refroidissement du composant, le procédé consiste au moins à insérer le corps mobile (52) entre l'élément mobile (90) solidaire du radiateur et la partie libre (78) de la face de refroidissement du composant et à pousser le corps mobile par l'élément mobile solidaire du radiateur pour séparer le composant du radiateur.

11. Procédé de démontage selon la revendication 10 **caractérisé en ce qu'**il comporte au moins les étapes suivantes :
- dévissage des vis de serrage (30) pour desserrer les transistors Tp plaqués contre le radiateur (50) par la barre métallique (26) et la lame de ressort (28),
- deuxième étape : mise en place de la barre de poussée (52) par sa première face (80) sur la première face (66) de la première surface (60) en L du radiateur et vissage des vis de poussée (90) dans les premiers trous filetés (86, 87).
- troisième étape : poursuite du vissage des vis de poussée (90) dans les premiers trous filetés (86, 87) du radiateur (50) pour déplacer la barre de poussée vers les transistors et l'amener en contact par sa deuxième face (81) avec la partie supérieure (78) des boîtiers des transistors de puissance Tp dépassant de la face de refroidissement (76) du radiateur,
- quatrième étape : poursuite du vissage des vis de poussée (90) dans les premiers trous filetés (86, 87) produisant un effort de poussée F sur la partie supérieure (78) des boîtiers des transistors Tp jusqu'à leur décollage du radiateur, puis retrait de la barre de poussée (52) et dévissage des vis de poussée (90) du radiateur (50).

## Claims

1. A device for disassembling at least one electronic power component (10) from a cooling radiator (16, 50) of the component, the component and the radiator each comprising a respective cooling surface (14, 22, 76) in thermal contact,
**characterised in that** a portion (78) of the cooling surface of the component mounted on the radiator is free and accessible by a mobile body (52) relative to the radiator, the radiator comprising a mobile element (90) integral with the radiator and designed to push the mobile body (52) against the free portion (78) of the cooling surface (22) of the component in order to separate the component from the radiator.

2. The disassembling device according to claim 1, **characterised in that** the mobile body (52) is a bar of rectangular cross-section S3 and the mobile element integral with the radiator is a screw (90) in a threaded hole (86, 87) of the radiator (50).

3. The disassembling device according to one of claims 1 to 2, **characterised in that** the radiator (50), the shape of which extends along an axis XX', comprises a body having a first cross-section S1 which is square at its ends (84, 85) and, along its length, parallel interior (60) and exterior (62) surfaces, each having an L-shape, the interior surface (60) comprising two perpendicular surfaces forming a first L, a first surface (66) and a second surface (67) perpendicular to the first.

4. The disassembling device according to any one of claims 1 to 3, **characterised in that** the transistors Tp of the parallelepiped boxes comprise an upper edge (78), a lower edge on the side of the tabs for electrical connection (32) with the board, a cooling surface (22) between these two edges designed to be applied against the cooling surface (76) of the radiator (50).

5. The disassembling device according to claim 4, **characterised in that** the radiator body has, in the central portion of its length, a second cross-section S2, which is also square but which has a square side narrower than the same side of the square of cross-section S1 at the ends of the radiator and which thus forms a receptacle (74) for positioning the transistor boxes Tp, the receptacle (74) comprising a cooling surface (76) of the radiator of height Hf connecting the L-shaped interior surface (60) and exterior surface (62) of the body of the radiator (50).

6. The disassembling device according to claim 5, **characterised in that** the upper edge (78) of the transistor box Tp (10) projects from the cooling surface (76) of the radiator (50) at a height Ht in order to ensure the implementation of a procedure for disassembling the transistors Tp.

7. The disassembling device according to claim 6, **characterised in that** the height of the projection Ht is 1mm.

8. The disassembling device according to one of claims 3 to 7, **characterised in that** the bar (52) of rectangular cross-section S3 is designed to slide along a first surface (80) of its four surfaces on the first surface (66) of the interior L-shaped surface (60) of the radiator (50) and to bear, with a second surface (81) perpendicular to the first (80), against the upper edges (78) of the transistor boxes (10) projecting from the cooling surface (76) of the radiator (50).

9. The disassembling device according to claims 3 to 8, **characterised in that** the radiator (50) comprises:
- at each of its two ends (84, 85), first threaded holes (86, 87) along the axes YY' perpendicular to the axis XX' opening towards the second surface (68) of the interior L-shaped surface (60),
- thrust screws (90) designed to be screwed into each of the first threaded holes (86, 87) of the radiator and opening towards the side of the second surface (68) of the first L-shaped surface,
- at each of its two ends (84, 85), in cross-section S1 of the radiator body, second threaded holes (88, 89) along the axes ZZ" perpendicular to the axis XX' opening either side of the receptacle (74) for the clamping screws (30).

10. A process for disassembling at least one electronic power component (10) from a cooling radiator (16, 50) of the component, by implementing a device according to any one of claims 1 to 9, the component and the radiator each comprising a respective cooling surface (14, 22, 76) in thermal contact,
**characterised in that** a portion (78) of the cooling surface of the component (10) mounted on the radiator is free and accessible by a mobile body (52) relative to the radiator (50), the radiator comprising a mobile element (90) integral with the radiator designed to push the mobile body (52) against the free portion (78) of the cooling surface of the component, the process at least consisting in inserting the mobile body (52) between the mobile element (90) integral with the radiator and the free portion (78) of the cooling surface of the component and pushing the mobile body with the mobile element integral with the radiator in order to separate the component from the radiator.

11. The process for disassembling according to claim 10, **characterised in that** it at least comprises the following steps:
- unscrewing the clamping screws (30) in order to loosen the transistors Tp held against the radiator (50) by the metal bar (26) and the leaf spring (28),
- second step: installing the thrust bar (52) with its first surface (80) onto the first surface (66) of the first L-shaped surface (60) of the radiator and screwing the thrust screws (90) into the first threaded screws (86, 87),
- third step: continuing tightening of the thrust screws (90) in the first threaded holes (86, 87) of the radiator (50) in order to move the thrust bar towards the transistors and bring said thrust bar into contact via its second surface (81) with the upper portion (78) of the boxes of the power transistors Tp projecting from the cooling surface (76) of the radiator,
- fourth step: continuing tightening of the thrust screws (90) in the first threaded holes (86, 87) producing a thrust force F on the upper part (78) of the transistor boxes Tp until they separate from the radiator, then removing the thrust bar (52) and unscrewing the thrust screws (90) from the radiator (50).

## Patentansprüche

1. Vorrichtung zum Demontieren von wenigstens einer elektronischen Leistungskomponente (10) eines Kühlers (16, 50) der Komponente, wobei die Komponente und der Kühler jeweils eine Kühlseite (14, 22, 76) in Wärmekontakt umfassen,
**dadurch gekennzeichnet, dass** ein Teil (78) der Kühlseite der auf dem Kühler montierten Komponente frei und für einen relativ zum Kühler beweglichen Körper (52) zugängig ist, wobei der Kühler ein bewegliches Element (90) einstückig mit dem Kühler umfasst, um den beweglichen Körper (52) gegen den freien Teil (78) der Kühlseite (22) der Komponente zu drücken, um die Komponente vom Kühler zu trennen.

2. Demontagevorrichtung nach Anspruch 1, **dadurch gekennzeichnet, dass** der bewegliche Körper (52) ein Stab mit rechteckigem Querschnitt S3 und das angeformte bewegliche Element des Kühlers eine Schraube (90) in einem Gewindeloch (86, 87) des Kühlers (50) ist.

3. Demontagevorrichtung nach Anspruch 1 oder 2, **dadurch gekennzeichnet, dass** der Kühler (50), mit länglicher Form entlang einer Achse XX', einen Körper mit einem ersten Querschnitt S1 hat, der an seinen Enden (84, 85) quadratisch geformt ist und über seine Länge eine parallele Innenfläche (60) und Außenfläche (62) hat, jeweils L-förmig, wobei die Innenfläche (60) zwei lotrechte Seiten, die ein erstes L bilden, eine erste Seite (66) und eine zweite Seite (67) lotrecht zur ersten hat.

4. Demontagevorrichtung nach einem der Ansprüche 1 bis 3, **dadurch gekennzeichnet, dass** die Transistoren Tp der quaderförmigen Gehäuse eine Oberkante (78), eine Unterkante auf der Seite von Laschen für eine elektrische Verbindung (32) mit der Platte, eine Kühlfläche (22) zwischen diesen Kanten zum Anlegen an die Kühlfläche (76) des Kühlkörpers (50) aufweisen.

5. Demontagevorrichtung nach Anspruch 4, **dadurch gekennzeichnet, dass** der Kühlerkörper im mittleren Teil seiner Länge einen zweiten Querschnitt S2 hat, der ebenso quadratisch ist, der aber eine quadratische Seite hat, die schmäler ist als dieselbe Seite des Quadrats mit Querschnitt S1 an den Enden des Kühlers und der somit eine Aufnahme (74) zum Positionieren der Transistorgehäuse Tp bildet, wobei die Aufnahme (74) eine Kühlseite (76) des Kühlers mit der Höhe Hf umfasst, die die Innenfläche (60) und die Außenfläche (62) in L-Form des Kühlerkörpers (50) verbindet.

6. Demontagevorrichtung nach Anspruch 5, **dadurch gekennzeichnet, dass** die Oberkante (78) des Transistorgehäuses Tp (10) von der Kühlseite (76) des Kühlers (50) bis zu einer Höhe Ht vorsteht, die die Ausführung eines Verfahrens zum Demontieren der Transistoren Tp gewährleistet.

7. Demontagevorrichtung nach Anspruch 6, **dadurch gekennzeichnet, dass** die Projektionshöhe Ht 1 mm beträgt.

8. Demontagevorrichtung nach einem der Ansprüche 3 bis 7, **dadurch gekennzeichnet, dass** der Stab (52) mit rechteckigem Querschnitt S3 so ausgelegt ist, dass er mit einer ersten Seite (80) seiner vier Seiten auf der ersten Seite (66) der Innenfläche (60) in L-Form des Kühlers (50) gleitet, und mit einer zweiten Seite (81) lotrecht zur ersten (80) an den Oberkanten (78) der Transistorgehäuse (10) anliegt, die von der Kühlfläche (76) des Kühlers (50) vorstehen.

9. Demontagevorrichtung nach einem der Ansprüche 3 bis 8, **dadurch gekennzeichnet, dass** der Kühler (50) Folgendes umfasst:
- an jedem seiner beiden Enden (84, 85) erste Gewindelöcher (86, 87) entlang den Achsen YY' lotrecht zur Achse XX', die zur zweiten Seite (68) der L-förmigen Innenfläche (60) hin mündet,
- Druckschrauben (90) zum Einschrauben in jedes der ersten Gewindelöcher (86, 87) des Kühlers, die auf der Seite der zweiten Seite (68) der ersten L-förmigen Fläche münden,
- an jedem seiner beiden Enden (84, 85), in dem Teil des Kühlerkörpers mit Querschnitt S1, zweite Gewindelöcher (88, 89) entlang der Achsen ZZ" lotrecht zur Achse XX', die auf beiden Seiten der Aufnahme (74) für die Klemmschrauben (30) münden.

10. Verfahren zum Demontieren von wenigstens einer elektronischen Leistungskomponente (10) eines Kühlers (16, 50) der Komponente durch Betreiben der Vorrichtung nach einem der Ansprüche 1 bis 9, wobei die Komponente und der Kühler jeweils eine Kühlseite (14, 22, 76) in Wärmekontakt haben,
**dadurch gekennzeichnet, dass** ein Teil (78) der Kühlseite der auf dem Kühler montierten Komponente (10) frei und für einen relativ zum Kühler (50) beweglichen Körper (52) zugänglich ist, wobei der Kühler ein bewegliches Element (90) einstückig mit dem Kühler zum Drücken des beweglichen Körpers (52) gegen den freien Teil (78) der Kühlseite der Komponente umfasst, wobei das Verfahren wenigstens darin besteht, dass der bewegliche Körper (52) zwischen das bewegliche Element (90) einstückig mit dem Kühler und dem freien Teil (78) der Kühlfläche der Komponente eingeführt und gegen den beweglichen Körper mit dem beweglichen Element einstückig mit dem Körper gedrückt wird, um die Komponente vom Kühler zu trennnen.

11. Verfahren zur Demontage nach Anspruch 10, **dadurch gekennzeichnet, dass** es wenigstens die folgenden Schritte beinhaltet:
- Abschrauben der Klemmschrauben (30) zum Lösen der Transistoren Tp, die von dem Metallstab (26) und der Blattfeder (28) gegen den Kühler (50) gehalten werden,
- zweiter Schritt: Installieren des Druckstabs (52) mit seiner ersten Seite (80) auf die erste Seite (66) der ersten L-förmigen Fläche (60) des Kühlers und Einschrauben der Druckschrauben (90) in die ersten Gewindelöcher (86, 87),
- dritter Schritt: Fortsetzen des Einschraubens der Druckschrauben (90) in die ersten Gewindelöcher (86, 87) des Kühlers (50), um den Druckstab in Richtung der Transistoren zu bewegen, und Inkontaktbringen des Druckstabs mit seiner zweiten Seite (81) mit dem oberen Teil (78) der Gehäuse der Leistungstransistoren Tp, die von der Kühlseite (76) des Kühlers vorstehen,
- vierter Schritt: Fortsetzen des Einschraubens der Druckschrauben (90) in die ersten Gewindelöcher (86, 87) zum Erzeugen einer Druckkraft F auf den oberen Teil (78) der Gehäuse der Transistoren Tp, bis sie vom Kühler getrennt sind, dann Entfernen des Druckstabs (52) und Abschrauben der Druckschrauben (90) vom Kühler (50).
